# EUROPÄISCHE PATENTSCHRIFT

(11) **EP 1 952 535 B1**
(45) Veröffentlichungstag und Bekanntmachung des Hinweises auf die Patenterteilung: **15.05.2019**
(21) Anmeldenummer: 06830078.9
(22) Anmeldetag: 22.11.2006
(51) Int. Cl.: H03K 17/687, H03K 17/082, H05B 33/08

(54) **SCHALTUNGSVORRICHTUNG MIT OBENLIEGENDEM BUCK-TRANSISTOR**
SWITCHING APPARATUS WITH AN UPPER BUCK TRANSISTOR
DISPOSITIF DE COMMUTATION A TRANSISTOR ABAISSEUR PLACE EN HAUT

(30) Priorität: 25.11.2005 DE 102005056255
(43) Veröffentlichungstag der Anmeldung: 06.08.2008
(73) Patentinhaber: OSRAM GmbH, 80807 München (DE)
(72) Erfinder: HUBER, Andreas, 82216 Maisach (DE); NIEDERMEIER, Peter, 80995 München (DE)
(86) Internationale Anmeldenummer: PCT/EP2006/068733
(87) Internationale Veröffentlichungsnummer: WO 2007/060168

(56) Entgegenhaltungen:
- WO-A-03/073596
- US-A- 4 423 341
- US-A- 5 126 651
- US-A- 5 404 095
- US-A- 6 094 087
- US-A1- 2004 041 620

## Beschreibung

### Technisches Gebiet

Die vorliegende Erfindung betrifft eine Schaltungsvorrichtung zum Betreiben einer Leuchteinrichtung mit einem Schaltelement, dessen Bezugselektrode an den positiven Pol einer Gleichspannungsquelle und dessen Arbeitselektrode an einen ersten Kontakt der Leuchteinrichtung anschließbar ist, und das eine Steuerelektrode aufweist. Ferner weist die Schaltungsvorrichtung eine Kontakteinrichtung auf, mit der ein zweiter Kontakt der Leuchteinrichtung an den negativen Pol der Gleichspannungsquelle anschließbar ist.

### Stand der Technik

In der Schrift US 5126651 (Gauen) ist eine Ansteuerschaltung für Schalttransistoren in einem Synchrongleichrichter offenbart. In der Schrift US 4423341 (Shelly) ist eine Ansteuerschaltung für einen Schalttransistor mit einer Totem-Pole Schaltung offenbart.

Für die Hintergrundbeleuchtung eines LCD-Monitors wird eine sogenannte Back Light Unit (BLU) verwendet. Diese wird gängigerweise mit LEDs realisiert. Zur Ansteuerung einer LED BLU wird häufig eine sogenannte Buck-Schaltung verwendet. Sie dient als Tiefsteller, wobei die hohe Versorgungsspannung auf das niedrigere Niveau einer Ansteuerspannung für die LED BLU zur Strombegrenzung herabgesetzt wird.

Für den Einsatz einer Buck-Schaltung in einer LED BLU ist es bei der Strommessung von Vorteil, wenn der Schalttransistor oben (d.h. auf positivem Potential) liegt und die Strommessung auf dem negativen Potential erfolgen kann. Hierdurch ergibt sich die Problematik, den Schalttransistor mit einer höheren Spannung als die Versorgungsspannung ansteuern zu müssen. Für die Ansteuerung eines oben liegenden Transistors sind für Netzspannungsanwendungen komplette IC Lösungen auf dem Markt. Typische High-Side-Treiber sind für Versorgungsspannungen von 600V geeignet. Derartige Treiber sind jedoch weniger für Versorgungsspannungen von 12 bis 100V einsetz- bar. Für diesen Spannungsbereich wäre somit ein speziell angefertigter Treiber notwendig. Dieser wäre aber verhältnismäßig teuer.

### Darstellung der Erfindung

Die Aufgabe der vorliegenden Erfindung besteht somit darin, eine kostengünstige Lösung zum Betreiben einer Leuchteinrichtung mit einer Buck-Schaltung, die ein oben liegendes Schaltelement aufweist, zu finden.

Erfindungsgemäß wird diese Aufgabe gelöst durch eine Schaltungsvorrichtung zum Betreiben einer Leuchteinrichtung mit einem Schaltelement, dessen Bezugselektrode an den positiven Pol einer Gleichspannungsquelle und dessen Arbeitselektrode an einen ersten Kontakt der Leuchteinrichtung anschließbar ist, und das eine Steuerelektrode aufweist, und einer Kontakteinrichtung, mit der ein zweiter Kontakt der Leuchteinrichtung an den negativen Pol der Gleichspannungsquelle anschließbar ist, wobei ein erster Transistor (Q1) mit seiner Bezugselektrode an den positiven Pol der Gleichspannungsquelle, mit seiner Arbeitselektrode an die Steuerelektrode des Schaltelements und mit seiner Steuerelektrode über einen Kondensator (C3) an einen extern ansteuerbaren Signalkontakt angeschlossen ist, und ein zweiter Transistor (Q2) mit seiner Bezugselektrode an die Kontakteinrichtung, mit seiner Arbeitselektrode an die Steuerelektrode des Schaltelements und mit seiner Steuerelektrode an den extern ansteuerbaren Signalkontakt angeschlossen ist.

Mit der erfindungsgemäßen Schaltungsvorrichtung kann ein teurer, als individuelles Bauelement gefertigter High-Side-Treiber für einen niedrigen Spannungsbereich vermieden werden. Es sind neben dem oben liegenden Schaltelement lediglich zwei kostengünstige Standard-Transistoren notwendig.

Vorzugsweise besteht das Schaltelement aus einem p-Kanal-Power-MOS-FET-Transistor vom Enhancement-Typ. Damit ist die von der Schaltungsvorrichtung angesteuerte Leuchteinrichtung grundsätzlich ausgeschaltet, wenn dieser Transistor nicht bewusst angeschaltet wird.

Der erste und zweite Transistor der Schaltungseinrichtung kann aus einem Feldeffekttransistor bestehen. Insbesondere eignen sich MOS-FETs zur Ansteuerung des Schaltelements. Alternativ können die beiden Transistoren auch Bipolartransistoren sein. Insbesondere ist es günstig, wenn der erste Transistor ein pnp-Biopolartransistor und der zweite Transistor ein npn-Bipolartransistor ist.

Vorzugsweise ist zwischen die Ausgangselektrode des zweiten Transistors und die Steuerelektrode des Schaltelements ein erstes RC-Glied und zwischen die Bezugselektrode des zweiten Transistors und die Kontakteinrichtung ein zweites RC-Glied geschaltet. Mit diesen RC-Gliedern ist die Schaltgeschwindigkeit des Schaltelements einstellbar.

Zwischen die Kontakteinrichtung und den zweiten Kontakt der Leuchteinrichtung kann ferner einer oder mehrere Shunt-Widerstände geschaltet werden. Damit lässt sich der Ausgangsstrom messen. Zur Erzielung des gewünschten Widerstandswerts kann eine entsprechende Widerstandsschaltung mit Widerständen geeigneter Verlustleistung eingesetzt werden.

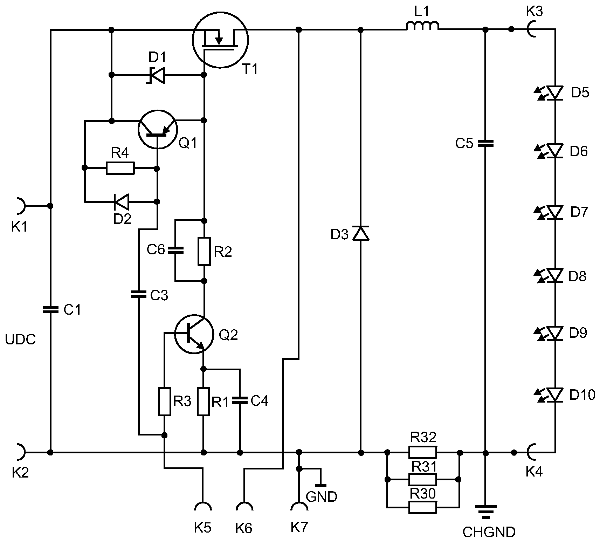

### Kurze Beschreibung der Zeichnung(en)

Die vorliegende Erfindung wird nun anhand der beigefügten Zeichnung näher erläutert, die ein Schaltbild einer erfindungsgemäßen Schaltungsvorrichtung für eine LED BLU zeigt.

### Bevorzugte Ausführung der Erfindung

Das nachfolgend näher geschilderte Ausführungsbeispiel stellt eine bevorzugte Ausführungsform der vorliegenden Erfindung dar.

Die in der Figur dargestellte Schaltung wird von einer nicht dargestellten Gleichspannungsquelle versorgt, welche für die Klemmen K1 und K2 eine Gleichspannung UDC liefert. Diese Gleichspannung ist hier kleiner als 100V. Zwischen die Klemmen K1 und K2 ist im Übrigen ein Kondensator C1 geschaltet, der in üblicher Weise zur Glättung der Gleichspannung UDC beiträgt. Die Klemme K2 repräsentiert das Massepotential.

An den positiven Pol der Gleichspannungsquelle, d.h. an die Klemme K1 ist ein P-Power-MOS-Transistor T1 geschaltet. Somit ergibt sich ein oben liegender Buck-Transistor. Die Ausgangselektrode des Buck-Transistors T1 ist über eine Drossel L1 an eine Klemme K3 angeschlossen. Die Klemme K2 ist über Shunt-Widerstände R30, R31 und R32, die miteinander parallel geschaltet sind, mit der Klemme K4 verbunden. Zwischen die Klemmen K3 und K4 ist ein LED-Array, hier vereinfacht durch eine Reihenschaltung von sechs Leuchtdioden D5 bis D10 dargestellt, geklemmt. Außerdem befindet sich zwischen den Klemmen K3 und K4 ein Kondensator C5 zum Glätten der Versorgungsspannung der Leuchtdioden. Eine Freilaufdiode D3 ist mit ihrer Kathode an die Ausgangselektrode des Buck-Transistors T1 und mit ihrer Anode an die Klemme K2 geschaltet. Der Buck-Transistor T1 und die Freilaufdiode D3 und L1 verwirklichen die Tiefstellerfunktion.

Die Steuerelektrode des Buck-Transistors T1 wird von zwei Bipolartransistoren Q1 und Q2 angesteuert, welche alternativ als MOS-FET-Transistoren ausgeführt sein können. Der Transistor Q1 ist als pnp-Transistor und der Transistor Q2 als npn-Transistor realisiert. Der Kollektor bzw. die Bezugselektrode des Transistors Q1 ist mit der Klemme K1 verbunden, während der Emitter bzw. die Ausgangselektrode des Transistors Q1 mit der Steuerelektrode des Buck-Transistors T1 verbunden ist. Zwischen Source und Gate des Transistors T1 befindet sich eine Zener-Diode D1 zum Schutz des Transistors Q1. Zwischen die Basis, d.h. die Steuerelektrode, und den Kollektor des Transistors Q1 ist eine Parallelschaltung einer Diode D2 und eines Widerstands R4 geschaltet.

Über eine Parallelschaltung eines Widerstands R2 und eines Kondensators C6 ist der Kollektor, d.h. die Ausgangselektrode, des Transistors Q2 an die Steuerelektrode des Buck-Transistors T1 geschaltet. Über eine weitere Parallelschaltung eines Widerstands R1 mit einem Kondensator C4 ist der Emitter, d.h. die Bezugselektrode des Transistors Q2 mit der Klemme K2 verbunden. Die Basis, d.h. die Steuerelektrode des Transistors Q2 ist über einen Widerstand R3 an eine Signalklemme K5 angeschlossen. Ebenso ist die Basis des Transistors Q1 über einen Kondensator C3 an die Klemme K5 angeschlossen. In die Klemme K5 ist ein Schaltsignal einspeisbar, um den Buck-Transistor T1 in geeigneter Weise anzusteuern. Da hierzu verwendete Gate-Signal besteht beispielsweise aus einer Folge von Rechteckimpulsen.

Weitere Klemmen K6 und K7 sind mit der Ausgangselektrode des Buck-Transistors T1 bzw. der Masse verbunden. Damit können beispielsweise bestimmte Abgriffe realisiert werden.

Der oben liegende Buck-Transistor T1 ist ein p-Kanal-Transistor vom Enhancement-Typ. Er ist somit normalerweise ausgeschaltet. Wenn der Transistor Q2 über R3 angesteuert wird, wird das Gate des Buck-Transistors T1 negativ gegenüber seinem Source (Bezugselektrode) und der Buck-Transistor T1 schaltet ein. Mit dem Abfallen des Gate-Signals am Buck-Transistor T1 wird der Transistor Q1 kurzfristig mit dem Kondensator C3 angesteuert. Er wird leitend und schaltet den Buck-Transistor T1 wieder ab.

Mit den Shunt-Widerständen R30, R31 und R32 wird der Ausgangsstrom gemessen. Prinzipiell reicht hierfür ein Widerstand, wenn der Widerstandswert und die Verlustleistung eine geeignete Größe besitzen. Meist ist es jedoch aus Kostengründen notwendig, einen speziellen Widerstandswert durch mehrere Widerstände zu erzielen.

Erfindungsgemäß ist es somit möglich, eine LED BLU durch zwei kostengünstige Standard-Transistoren Q1, Q2 mit einem p-Power-MOS-Transistor T1 zu betreiben. Für den Spannungsbereich von bis zu 60V sind ausreichend günstige p-Kanal-Power-MOS-FETs am Markt verfügbar.

## Patentansprüche

1. Schaltungsvorrichtung zum Betreiben einer Leuchteinrichtung mit
- einem Schaltelement (T1) dessen Bezugselektrode an den positiven Pol (K1) einer Gleichspannungsquelle und dessen Arbeitselektrode an einen ersten Kontakt (K3) der Leuchteinrichtung (D5 bis D10) anschließbar ist, und das eine Steuerelektrode aufweist, und
- einer Kontakteinrichtung, mit der ein zweiter Kontakt (K4) der Leuchteinrichtung (D5 bis D10) an den negativen Pol (K2) der Gleichspannungsquelle anschließbar ist,
**dadurch gekennzeichnet, dass**
- ein erster Transistor (Q1) mit seiner Bezugselektrode an den positiven Pol (K1) der Gleichspannungsquelle, mit seiner Arbeitselektrode an die Steuerelektrode des Schaltelements (T1) und mit seiner Steuerelektrode über einen Kondensator (C3) an einen extern ansteuerbaren Signalkontakt (K5) angeschlossen ist und
- ein zweiter Transistor (Q2) mit seiner Bezugselektrode an die Kontakteinrichtung, mit seiner Arbeitselektrode an die Steuerelektrode des Schaltelements (T1) und mit seiner Steuerelektrode an den extern ansteuerbaren Signalkontakt (K5) angeschlossen ist.

2. Schaltvorrichtung nach Anspruch 1, wobei das Schaltelement (T1) aus einem p-Kanal-Power-MOS-FET-Transistor vom Enhancement-Typ besteht.

3. Schaltungsvorrichtung nach Anspruch 1 oder 2, wobei der erste und zweite Transistor (Q1, Q2) jeweils ein Feldeffekt-Transistor ist.

4. Schaltungsvorrichtung nach Anspruch 1 oder 2, wobei der erste Transistor (Q1) ein pnp- Bipolartransistor ist.

5. Schaltungsvorrichtung nach Anspruch 1, 2 oder 4, wobei der zweite Transistor (Q2) ein npn-Bipolartransistor ist.

6. Schaltungsvorrichtung nach einem der vorhergehenden Ansprüche, wobei zwischen die Arbeitselektrode des zweiten Transistors (Q2) und die Steuerelektrode des Schaltelements (T1) ein erstes RC-Glied (R2, C6) und zwischen die Bezugselektrode des zweiten Transistors (Q2) und die Kontakteinrichtung ein zweites RC-Glied (R1, C4) geschaltet ist.

7. Schaltungsvorrichtung nach einem der vorhergehenden Ansprüche, wobei zwischen die Kontakteinrichtung und den zweiten Kontakt der Leuchteinrichtung (K4) einer oder mehrere Shunt-Widerstände (R30, R31, R32) geschaltet sind.

## Claims

1. Circuit apparatus for operating a luminous device with
- a switching element (T1), whose reference electrode can be connected to the positive pole (K1) of a DC voltage source and whose working electrode can be connected to a first contact (K3) of the luminous device (D5 to D10) and which has a control electrode, and
- a contact device, with which a second contact (K4) of the luminous device (D5 to D10) can be connected to the negative pole (K2) of the DC voltage source,
**characterized in that**
- a first transistor (Q1) is connected with its reference electrode to the positive pole (K1) of the DC voltage source, with its working electrode to the control electrode of the switching element (T1) and with its control electrode, via a capacitor (C3), to an externally drivable signal contact (K5), and
- a second transistor (Q2) is connected with its reference electrode to the contact device, with its working electrode to the control electrode of the switching element (T1) and with its control electrode to the externally drivable signal contact (K5) .

2. Circuit apparatus as claimed in Claim 1, the switching element (T1) comprising a p-channel power MOSFET transistor of the enhancement type.

3. Circuit apparatus as claimed in Claim 1 or 2, the first and second transistor (Q1, Q2) in each case being a field effect transistor.

4. Circuit apparatus as claimed in Claim 1 or 2, the first transistor (Q1) being a pnp bipolar transistor.

5. Circuit apparatus as claimed in Claim 1, 2 or 4, the second transistor (Q2) being an npn bipolar transistor.

6. Circuit apparatus as claimed in one of the preceding claims, a first RC element (R2, C6) being connected between the workingw electrode of the second transistor (Q2) and the control electrode of the switching element (T1), and a second RC element (R1, C4) being connected between the reference electrode of the second transistor (Q2) and the contact device.

7. Circuit apparatus as claimed in one of the preceding claims, one or more shunt resistors (R30, R31, R32) being connected between the contact device and the second contact of the luminous device (K4).

## Revendications

1. Dispositif de commutation pour faire fonctionner un dispositif d'éclairage, comprenant :
- un élément de commutation (T1), dont l'électrode de référence peut être raccordée au pôle positif (K1) d'une source de tension continue et dont l'électrode de travail peut être raccordée à un premier contact (K3) du dispositif d'éclairage (D5 à D10), et qui comporte une électrode de commande, et
- un dispositif de contact par lequel un deuxième contact (K4) du dispositif d'éclairage (D5 à D10) peut être raccordé au pôle négatif (K2) de la source de tension continue,
**caractérisé en ce que** :
- un premier transistor (Q1) est raccordé par son électrode de référence au pôle positif (K1) de la source de tension continue, par son électrode de travail à l'électrode de commande de l'élément de commutation (T1) et par son électrode de commande, via un condensateur (C3), à un contact de signal (K5) pouvant être commandé de l'extérieur et
- un deuxième transistor (Q2) est raccordé par son électrode de référence au dispositif de contact, par son électrode de travail à l'électrode de commande de l'élément de commutation (T1) et par son électrode de commande au contact de signal (K5) commandable de l'extérieur.

2. Dispositif de commutation selon la revendication 1, l'élément de commutation (T1) se composant d'un transistor de puissance MOSFET à canal p de type à enrichissement.

3. Dispositif de commutation selon la revendication 1 ou 2, le premier et le deuxième transistor (Q1, Q2) étant respectivement un transistor à effet de champ.

4. Dispositif de commutation selon la revendication 1 ou 2, le premier transistor (Q1) étant un transistor bipolaire pnp.

5. Dispositif de commutation selon la revendication 1, 2 ou 4, le deuxième transistor (Q2) étant un transistor bipolaire npn.

6. Dispositif de commutation selon l'une des revendications précédentes, entre l'électrode de travail du deuxième transistor (Q2) et l'électrode de commande de l'élément de commutations (T1) étant monté un premier élément RC (R2, C6) et, entre l'électrode de référence du deuxième transistor (Q2) et le dispositif de contact, un deuxième élément RC (R1, C4) .

7. Dispositif de commutation selon l'une des revendications précédentes, entre le dispositif de contact et le deuxième contact du dispositif d'éclairage (K4) étant montées une ou plusieurs résistances shunt (R30, R31, R32).
